# EUROPEAN PATENT APPLICATION

(11) **EP 1 496 542 A2**
(43) Date of publication of application: **12.01.2005**
(21) Application number: 04015990.7
(22) Date of filing: 07.07.2004
(51) Int. Cl.: H01L 21/288, H01L 21/00

(54) **Method and apparatus for forming capping film**

(30) Priority: 07.07.2003 JP 2003192778
(71) Applicant: EBARA CORPORATION, Ohta-ku, Tokyo (JP)
(72) Inventor: Saijo, Yasuhiko, Fujisawa-shi, Kanagawa-ken (JP); Shimoyama, Masashi, Fujisawa-shi, Kanagawa-ken (JP); Yokota, Hiroshi, Fujisawa-shi, Kanagawa-ken (JP); Tashiro, Akihiko, Ohta-ku, Tokyo (JP); Wang, Xinming, Ohta-ku, Tokyo (JP); Takagi, Daisuke, Ohta-ku, Tokyo (JP)
(74) Representative: Klang, Alexander H.

(57) **Abstract**

A capping film serving as an interconnect protective film formed on a surface of interconnect metal on a semiconductor substrate is formed after forming a catalyst layer for electroless plating under low oxygen concentration condition. A method for forming a capping film for protecting a surface of interconnect metal includes preparing a metal catalyst solution containing a metal element nobler than interconnect metal and having dissolved oxygen concentration of 7 ppm or less, bringing said metal catalyst solution into contact with a surface of interconnect metal to form a metal catalyst layer on the surface of the interconnect metal, and performing electroless plating to form a capping film on the surface of the interconnect metal.

## Description

### BACKGROUND OF THE INVENTION

### Field of the Invention:

The present invention relates to an interconnect formation technology in a semiconductor device fabrication process, and more particularly to a method and apparatus for forming a capping film serving as an interconnect protective film formed on a surface of interconnect metal on a semiconductor substrate after forming a catalyst layer for electroless plating under low oxygen concentration condition in which dissolution of the interconnect metal caused by oxygen is reduced.

### Description of the Related Art:

Since copper interconnects which have been widely used recently in semiconductor devices can obtain lower resistance and higher reliability than aluminum alloy interconnects, the copper interconnects are gaining more supremacy and importance than the aluminum alloy interconnects in fine devices in which signal transmission delay caused by parasitic resistance and parasitic capacitance of interconnects is predominant.

The copper interconnect technology is different from the aluminum alloy interconnect technology in that application of micro-fabrication by a dry etching technology is difficult. Therefore, as a pattern formation technology which replaces a metal dry etching technology which has been put to practical use widely over a long term of years in an aluminum alloy interconnect technology, a copper damascene technology is required.

The outline of processes in the copper damascene technology is as follows:

First, trenches are formed in an insulating film formed on a semiconductor substrate, and a barrier layer for suppressing diffusion of copper is formed on the insulating film. Then, copper is embedded in the trenches by plating or the like, and unnecessary copper deposited on the outside of the trenches is removed by chemical mechanical polishing (CMP) or the like so that the surface of the copper layer embedded in the trenches is substantially flush with the surface of the insulating film, thereby forming interconnects in the trenches. By application of such micro-fabrication technology to the insulating film, copper interconnects can be made minute.

However, since copper is liable to be oxidized compared with aluminum, in order to prevent oxidization of the surfaces of the copper interconnects or increase adhesiveness of the surfaces of the copper interconnects to the subsequent layer, a film having a high electromigration resistance such as cobalt tungsten phosphide (CoWP) or the like is required as a capping film.

However, it is reported that since it is difficult to form a CoWP film on the surfaces of the copper interconnects directly by electroless plating, it is effective to form another metal layer and then form a CoWP film. As a metal used for this purpose, catalytically active metal on which hypophosphorous acid used for an electroless plating solution acts as a reducing agent is used. Such metal includes palladium, for example (N. Petrov, Y. Sverdlov, and Y. Shacham-Diamand, Journal of The Electrochemical Society, 149, C187 (2002)).

As described above, in order to form an alloy film such as a CoWP film on surfaces of copper interconnects as a capping film by electroless plating, it is necessary to form a catalyst layer made of metal such as palladium nobler than copper on the surface of copper as a catalyst for electroless plating of such alloy. In a catalyst solution. for forming the catalyst layer, it is considered that the sulfate ion which is also used for plating copper interconnects is appropriate for an anion which forms a pair with a metal ion of the metal catalyst to form an electrolyte solution.

However, in a case where a palladium sulfate solution is used as a catalyst solution, since solubility of palladium sulfate depends on a pH, it is necessary to lower a pH of the palladium sulfate solution in order to keep palladium ion concentration and deposit palladium efficiently. However, if the pH of the palladium sulfate solution is low, then surfaces of copper interconnects might be excessively dissolved (etched) with replacement reaction of palladium, and thus the performance of copper interconnects to be expected cannot be obtained even if a CoWP film is formed as a capping film in the subsequent process.

In a case where the pH of the palladium sulfate solution is low, dissolution of copper caused by acidity of sulfate is considered to be one of the causes, but the present inventors have found that in a process for forming a metal catalyst layer for electroless plating on surfaces of copper interconnects, dissolved oxygen in a plating solution induces electrochemical side reaction and excess dissolution of copper progresses due to dissolution of copper simultaneously with reduction reaction of oxygen.

Further, it has been found that in a wet process using an electrolyte, crystal grain structures in the copper interconnects not only increases electrical resistance but also exerts a great influence on corrosion characteristic. It has also been found that the same holds true for adhesiveness of the interface between the barrier layer and the copper film. In general, the smaller the width of interconnect is, the smaller crystal grain is. When crystal grain of copper is small, grain boundary and twin crystal increase, and thus electrical resistance of copper itself increases and corrosion characteristic is also greatly affected. If corrosion takes place at the interface between the surfaces of the interconnects and the barrier layer, then the surfaces of the copper interconnects are roughened. It is considered that in a case where frequencies of signals increase due to demand for further higher processing speed of LSI from now on, such roughness of the surfaces of the copper interconnects exerts a great influence on transmission loss caused by a skin effect that current converges on the surfaces of the interconnects and their neighborhood.

In some cases, such corrosion of the copper interconnects causes a lowering of reliability of the copper interconnects such as electromigration or stress migration.

### SUMMARY OF THE INVENTION

The present invention has been made in view of the above drawbacks in the related art. It is therefore an object of the present invention to provide a method and apparatus for forming a capping film which can suppress excess corrosion of interconnect metal, and can prevent a high processing speed, characteristic and reliability of LSI from being impaired.

In order to solve the above problems, the present inventors have intensely studied and found that in a process for forming a metal catalyst layer for electroless plating on surfaces of copper interconnects, dissolved oxygen in a plating solution induces electrochemical side reaction, and excess dissolution of copper progresses due to dissolution of copper simultaneously with reduction reaction of oxygen.

This phenomenon is not limited to a plating solution during formation of a capping film. In order to lower dissolved oxygen concentration of a plating solution effectively, not only making the gas phase contacting the plating solution under low oxygen concentration condition but also making the entire capping film forming process under low oxygen concentration condition, and further making an atmosphere in the planarization process such as CMP which is the previous process of the capping film forming process and an atmosphere between such processes under low oxygen concentration condition can prevent copper from being dissolved excessively.

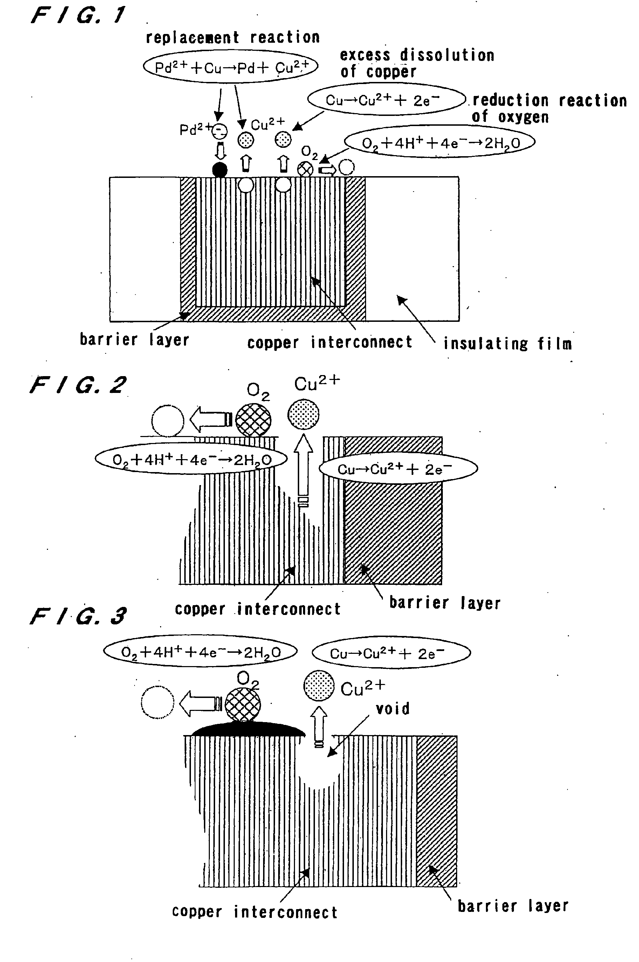

Specifically, as shown in FIG. 1, palladium to be a catalyst for forming a capping film is deposited on copper interconnects by replacement reaction with copper, and at the same time, reduction reaction of dissolved oxygen takes place on a surface of copper as side reaction in an electrolyte containing dissolved oxygen, particularly a liquid (containing palladium sulfate) having a low pH. Thus, copper is excessively dissolved (etched) more than an amount caused by replacement reaction, and hence cross-sectional areas of copper interconnects are decreased and interconnect resistance is increased.

The progress of this side reaction means a formation of local cell because the reduction reaction of oxygen and the oxidation reaction of copper occur in pair separately and locally on the surface of the copper as shown in FIG. 2, for example. Therefore, dissolution reaction of copper is locally concentrated to cause excessive dissolution (etching) of copper and exert a great effect on an increase of interconnect resistance.

Further, as shown in FIG. 3, since reduction reaction of oxygen (i.e. oxygen is subjected to reduction reaction) is electrochemical reaction, such reduction reaction takes place also on the surface of palladium deposited on the copper interconnects. Therefore, reduction reaction of oxygen takes place on the surface of palladium and dissolution reaction of copper takes place in copper portion around the deposited palladium by an amount corresponding to the reduction reaction of oxygen, and hence dissolution of copper progresses preferentially around palladium to form voids, resulting in a remarkable increase in interconnect resistance.

In this manner, the present inventors have had knowledge that excessive dissolution of copper is mainly caused by dissolved oxygen, and have found that in order to prevent excessive dissolution of copper interconnects, dissolved oxygen concentration of a catalyst solution used in catalyst-imparting treatment for forming a capping film by electroless plating should be reduced.

Since the dissolved oxygen concentration of the catalyst solution depends on distribution equilibrium in accordance with a partial pressure of oxygen in an atmosphere (gas phase), the more an amount of oxygen removed from the catalyst solution is, the higher a dissolution velocity of oxygen from an atmosphere (gas phase) into the catalyst solution is. Therefore, it is desirable to maintain the whole process as to the catalyst-imparting treatment in a low oxygen concentration state by reducing the partial pressure of oxygen (low oxygen concentration condition) in an atmosphere(gas phase) besides removing oxygen from the catalyst solution (deaeration). Further, since the low oxygen concentration condition in an atmosphere (gas-phase) is also important as measures against corrosion of copper interconnects in a wet process during the planarization process such as CMP which is the previous process of the catalyst-imparting treatment process, the low oxygen concentration condition should not be restricted only in the catalyst-imparting treatment process, but should be kept through the processes including the step between both the above processes.

In order to achieve the above object, according to a first aspect of the present invention, there is provided a method for forming a capping film for protecting a surface of interconnect metal, comprising: preparing a metal catalyst solution for electroless plating containing a metal element nobler than interconnect metal and having dissolved oxygen concentration of 7 ppm or less; bringing the metal catalyst solution into contact with a surface of the interconnect metal to form a metal catalyst layer on the surface of the interconnect metal; and performing electroless plating to form a capping film on the surface of the interconnect metal.

In a preferred aspect of the present invention, the interconnect metal comprises copper or copper alloy, and the metal element nobler than the interconnect metal comprises at least one of metal element selected from gold, silver, and platinum group metals.

In a preferred aspect of the present invention, an apparatus used for the step for forming the metal catalyst layer on the surface of the interconnect metal is placed in an atmosphere in which oxygen concentration is lower than oxygen concentration in the normal atmosphere.

In a preferred aspect of the present invention, formation of the metal catalyst layer is performed by replacement reaction of metal of the interconnect metal with metal catalyst.

In a preferred aspect of the present invention, the metal catalyst solution which dissolves palladium in inorganic acid or organic acid or a mixed solvent of inorganic acid and organic acid is used for forming the metal catalyst layer.

In a preferred aspect of the present invention, the capping film comprises a film containing at least one component selected from CoWP, NiP, NiB, CoP, NiWP, NiCoP, CoWB, NiWB, CoMoP, CoMoB and CoB.

In a preferred aspect of the present invention, wherein a step before the step for forming the metal catalyst layer on the surface of the interconnect metal comprises a planarization step of an interconnect substrate by a wet process, and oxygen concentration of an atmosphere between units used for the planarization step and the step for forming the metal catalyst layer on the surface of the interconnect metal and within the units is lower than that of the normal atmosphere.

According to a second aspect of the present invention, there is provided an apparatus for forming a capping film for protecting a surface of interconnect metal, comprising:
a catalyst-imparting unit for bringing a metal catalyst solution for electroless plating containing a metal element nobler than interconnect metal into contact with a surface of the interconnect metal and forming a metal catalyst layer on the surface of the interconnect metal; and a plating unit for forming a capping film on the surface of the interconnect metal by electroless plating; wherein the catalyst-imparting unit has a device configured to supply and discharge the metal catalyst solution and the plating unit has a device configured to supply and discharge a plating solution; at least the catalyst-imparting unit is placed in a housing which limits an inflow of outer air; the catalyst-imparting unit comprises a deaeration device configured to deaerate the metal catalyst solution; and the housing for the catalyst-imparting unit comprises a low oxygen concentration device configured to replace an atmosphere in said housing with an inert gas or a low oxygen concentration gas.

In a preferred aspect of the present invention, the deaeration device lowers dissolved oxygen concentration in the metal catalyst solution to 7 ppm or less.

In a preferred aspect of the present invention, the interconnect metal comprises copper, the metal catalyst comprises palladium, and the capping film comprises a film containing at least one component selected from CoWP and NiP.

In a preferred aspect of the present invention, further comprising a planarization unit coupled to the apparatus for forming the capping film, the planarization unit being configured to planarize an interconnect substrate by a wet process; wherein the planarization unit, the catalyst-imparting unit, and the plating unit and spaces between the units are disposed in a housing which limits an inflow of outer air, and the housing comprises a low oxygen concentration device configured to replace an atmosphere in the housing with an inert gas or a low oxygen concentration gas.

The above and other objects, features, and advantages of the present invention will be apparent from the following description when taken in conjunction with the accompanying drawings which illustrates preferred embodiments of the present invention by way of example.

### BRIEF DESCRIPTION OF THE DRAWINGS

FIG. 1 is a schematic view showing dissolution reaction of copper caused by replacement reaction which takes place on surfaces of metal (copper) interconnects to replace metal catalyst (palladium) with copper and reduction reaction of dissolved oxygen;
FIG. 2 is a schematic view showing the manner in which local cell is formed due to reduction reaction of oxygen (i.e. oxygen is subjected to reduction reaction) and oxidation reaction of copper (i.e. copper is subjected to oxidation reaction) which take place simultaneously on the surface of copper;
FIG. 3 is a schematic view showing the manner in which copper is preferentially dissolved around palladium to form voids;
FIG. 4 is a schematic plan view showing an apparatus for forming a capping film according to an embodiment of the present invention;
FIG. 5 is a schematic plan view showing an overall structure of an apparatus for forming a capping film and a planarization apparatus according to an embodiment of the present invention;
FIG. 6 is a graph showing frequency change with time in a case where a palladium sulfate solution having low dissolved oxygen concentration is used and in a case where normal palladium sulfate is used according to Electrochemical Quartz Crystal Microbalance;
FIG. 7 is a graph showing the relationship between the degree of deaeration of a catalyst-imparting solution and an increasing rate of interconnect resistance;
FIG. 8A is a side view of a catalyst-imparting treatment apparatus in which a processing surface of a substrate is cleaned;
FIG. 8B is a side cross-sectional view of FIG. 8A;
FIG. 9 is a system diagram of the catalyst-imparting treatment apparatus;
FIG. 10A is a side view showing the state in which a lid member is turned to open an opening of a processing tank and a substrate holder is raised in the catalyst-imparting treatment apparatus; and
FIG. 10B is a side cross-sectional view of FIG. 10A.

### DETAILED DESCRIPTION OF THE PREFERRED EMBODIMENTS

According to the method of the present invention, a metal catalyst solution for electroless plating which contains a metal element nobler than interconnect metal and has a reduced dissolved oxygen concentration is used for catalyst-imparting treatment for forming a capping film to protect a surface of the interconnect metal by electroless plating.

The interconnect metal used in the present invention is not limited, but includes copper and a copper alloy. The interconnect metal is used for forming copper interconnects embedded through a barrier layer in recesses formed in an insulating film deposited on a silicon substrate.

Further, the capping film formed by the method according to the present invention serves to protect the surface of the interconnect metal such as copper from oxidization or the like, and a material for the capping film includes CoWP, NiP, NiB, CoP, NiWP, NiCoP, CoWB, NiWB, CoMoP, CoMoB, CoB, and the like.

The metal catalyst solution for electroless plating used in the method according to the present invention contains a metal element nobler than the interconnect metal, and has dissolved oxygen concentration of 7ppm or less.

The metal element which is contained in the metal catalyst solution for electroless plating (hereinafter referred to as "metal catalyst solution") and is nobler than the interconnect metal includes a metal element selected from gold, silver and platinum group metals. Among these metal elements, palladium which belongs to platinum group metals is preferable.

In order to dissolve the metal element and form an electrolyte solution, an anion which forms a pair with a metal ion (cation) is necessary. As a compound providing the anion, inorganic acids such as sulfuric acid, hydrochloric acid or nitric acid and organic acids such as acetic acid, formic acid or oxalic acid may be used. Among these, the desirable one is sulfuric acid.

On the other hand, in order to lower dissolved oxygen concentration in a metal catalyst solution to 7ppm or less, it is desirable to reduce oxygen by deaeration. As a deaeration means, any method may be selected from a bubbling method using an inert gas, a removing method using a membrane such as a polymer membrane or an inorganic membrane, a method for removing gas components under vacuum, and a method for spraying a metal catalyst solution in an inert gas atmosphere. Alternatively, a combination of two or more of the above methods may be used.

As the above inert gas, it is desirable to use an inert gas which is humidified to such a degree that a metal catalyst solution is prevented from being dried on a wafer after concentration of the metal catalyst solution and metal catalyst-imparting treatment, and it is desirable to use any one of nitrogen, argon and helium, or a combination of two or more of these gases. As a method for humidifying an inert gas, any conventional method may be used, and pure water is preferable as water to be used. Further, in order to remove an influence caused by contamination of the inert gas, the inert gas having as much purity as possible should be used. Further, it is desirable to perform bubbling in an agitation state of the metal catalyst solution rather than a stationary state of the metal catalyst solution. Further, in the case of treating a solution containing sulfuric acid by bubbling, sulfurous acid gas is generated as exhaust gas, and hence such exhaust gas should be delivered to an exhaust gas treatment apparatus through an exhaust duct.

The dissolved oxygen concentration in the metal catalyst solution which has been subjected to the above deaeration treatment can be measured and monitored using an oxygen permeation type dissolved oxygen meter or the like.

When the dissolved oxygen concentration in the metal catalyst solution is measured using the oxygen permeation membrane type dissolved oxygen meter, if the measuring section remains soaked in the solution, then there is a possibility that components of a liquid inside the measuring section ooze out through an oxygen permeation membrane. Therefore, the measuring section should be soaked in the metal catalyst solution only at the time of measurement. Metal catalyst is deposited on the interconnect metal by replacement precipitation. While the metal catalyst solution is repeatedly used in the catalyst layer formation process, the concentration of the interconnect metal ion such as copper ion dissolved by replacement reaction increases, thus adversely affecting conditions of catalyst layer formation. Therefore, when the interconnect metal ion reaches a predetermined concentration or higher after the metal catalyst solution is used for a certain period of time, it is desirable to replace the used metal catalyst solution with a new metal catalyst solution.

For example, in a case where a palladium sulfate solution is used as a metal catalyst solution, the palladium sulfate solution should'be replaced, for example, when the molarity of copper exceeds five times the molarity of palladium, and more preferably when the molarity of copper exceeds twice the molarity of palladium.

A capping film may be formed using the above-described metal catalyst solution as follows:

First, a surface of interconnect metal is cleaned, and pretreatment is performed according to the conventional method to remove oxide film or the like from the surface of the interconnect metal. In this pretreatment, in order to remove oxide on the surface of copper and cause replacement reaction with metal catalyst efficiently, it is desirable to use aqueous solution containing a compound selected from sulfuric acid, nitric acid, nitrous acid, phosphoric acid, oxalic acid, formic acid, acetic acid, citric acid, malic acid and a halogen compound group (hydrofluoric acid, hydrochloric acid, etc.). It is desirable that dissolved oxygen concentration in the aqueous solution of the compound is controlled, as required, to suppress excess etching caused by reduction reaction of dissolved oxygen. At this time, the pretreatment is performed immediately after a planarization process such as CMP which is a previous process, and if there is no contamination or an oxide film is not formed until a metal catalyst-imparting process, then such pretreatment can be omitted. Specifically, it is preferable that a liquid used and an atmosphere (gas phase) in a wet process should be under low oxygen concentration condition in the previous process and the step between the processes up to the metal catalyst-imparting process. Low oxygen concentration of the liquid used may be achieved by the conventional method, and low oxygen concentration of atmosphere (gas phase) may be achieved preferably using any one of nitrogen, argon and helium or a combination of two or more of these gases.

If the pretreatment is required separately, it is preferable that the surface of the interconnect metal, for example, the surface of copper should be cleaned by pure water immediately after the pretreatment to prevent re-oxidization of the surface of the interconnect metal, and the substrate should be transferred to the subsequent catalyst layer formation process before water content remaining on the surface of the interconnect metal is dried.

Next, the surface of the interconnect metal which has been cleaned is brought into contact with the metal catalyst solution to form a metal catalyst layer. As the contact method, for example, a method for spraying a metal catalyst solution such as a palladium sulfate solution over the entire surface of the wafer including the interconnects formed by the interconnect metal such as copper or a method for soaking the processing surface of the wafer or the entire surface of the wafer in the metal catalyst solution may be employed. In this manner, the metal catalyst such as palladium can be uniformly deposited on the interconnects such as copper by replacement reaction (displacement plating).

The contact time between the surface of the interconnect metal and the metal catalyst solution, the amount of the metal catalyst solution contacting the surface of the interconnect metal, or the temperature of the metal catalyst solution used are required to be changed depending on the composition of the metal catalyst solution or the manner of contact. In the case of the method for soaking the processing surface of the wafer or the entire wafer, in general, the catalyst solution has a temperature of 20 to 25°C, a palladium concentration of 10 ppm or more, and a certain sulfuric acid concentration so that the pH of the metal catalyst solution is 2 or less, and the surface of the interconnect metal should be brought into contact with such metal catalyst solution for about 60 seconds. Further, this contact reaction is preferably carried out under oxygen-free or low oxygen concentration condition.

It is desirable that immediately after the catalyst layer formation process is conducted in the above manner, the surface of the interconnect metal is cleaned by pure water, and then the electroless plating treatment process for forming a capping film is started before water content remaining on the surface of the wafer is dried.

The electroless plating for forming the capping film is called "cap plating", and a plated alloy layer composed of various components as described above is formed. Specifically, the electroless plating of NiP, NiB, CoP, NiWP, NiCoP, CoWB, NiWB, CoMoP, CoMoB, CoB, and the like besides CoWP is performed, and plating conditions for the electroless plating are different from one another in the capping films to be formed.

For making an overall apparatus under low oxygen concentration atmosphere, an enclosed space should be constructed in the overall apparatus, and a gas is circulated in the apparatus to control the temperature and humidity in the enclosed space. However, if it is impossible to form an enclosed structure in the overall apparatus, an enclosed space structure should be used in each wet process unit and a wafer transferring area between the processing units so that an atmosphere therein is prevented from being exposed to the open air and is kept in low oxygen concentration atmosphere, and an opening and closing structure should be used so that wafers can be carried in or carried out from the process unit in which deoxygenation is required, without being exposed to the open air. Further, it is considered that an active gas such as oxygen gas is generated according to the wet process, and hence such generated gas should be delivered to an exhaust gas treatment apparatus through an exhaust duct.

The oxygen concentration of gas atmosphere which has been subjected to the above deaeration treatment can be measured and monitored using an oxygen analyzer meter which employs a zirconia-ceramic sensor, for example. An abnormality of the apparatus can be detected by the oxygen meter, and when some work is performed in the apparatus, whether the apparatus should be opened or not can be judged. Further, since the apparatus becomes in an oxygen-free state, in consideration of safety of a worker, two or more oxygen sensors having the same function should be provided at locations where the oxygen sensors are required.

When the some work is carried out by the worker, it is necessary to restore an atmosphere in the apparatus to the normal atmosphere. Therefore, it is desirable that an intake duct and an exhaust duct are provided to deliver an exhaust gas drawn in from the intake duct to the exhaust gas treatment apparatus through the exhaust duct.

Next, an apparatus for effectively carrying out the method according to the present invention will be described below with reference to the drawings.

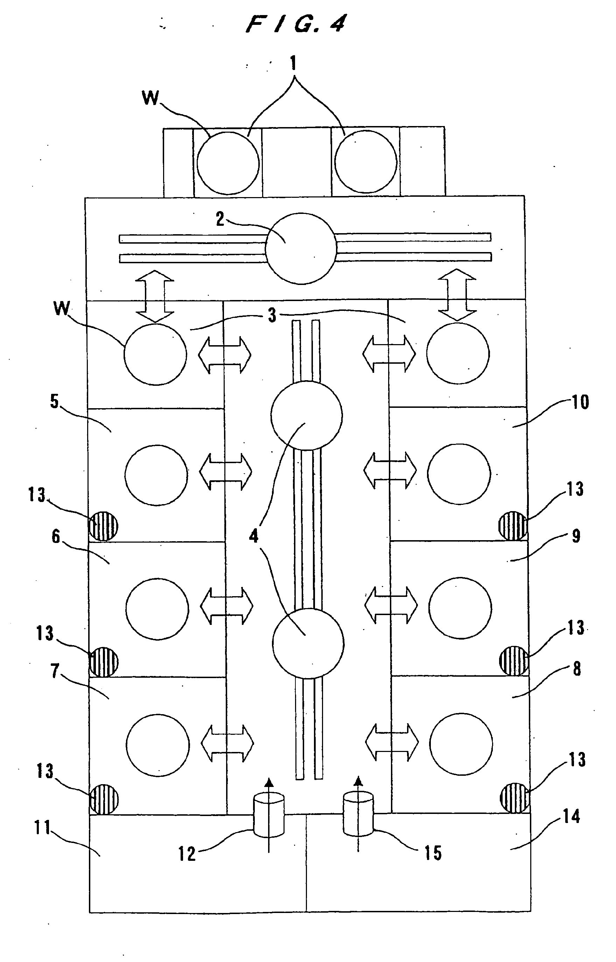

FIG. 4 is a schematic plan view showing an overall structure of a plating apparatus for forming a capping film according to the method of the present invention. A plating apparatus comprises a loading/unloading unit 1, a transfer robot 2, atmospheric gas replacement chambers 3, transfer robots 4, a pretreatment unit 5, a pure water cleaning unit 6, a catalyst-imparting unit 7, a pure water cleaning unit 8, a plating unit 9, and a cleaning and drying unit 10. Further, the plating apparatus comprises a gas supply unit 11 for reducing oxygen concentration which can control the temperature and humidity in the apparatus, a gas supply port 12 for reducing oxygen concentration, exhaust ports 13 provided in the respective units for circulating a gas or discharging the gas to an exhaust gas treatment apparatus, a gas circulating unit 14 for circulating a gas through the exhaust ports 13, and a circulating gas supply port 15.

In the plating apparatus according to the present invention, a low oxygen concentration gas whose temperature and humidity is controlled is supplied from the gas supply unit 11 to the interior of the apparatus through the gas supply port 12, whereby an atmosphere of the transfer robots 4, the pretreatment unit 5, the pure water cleaning unit 6, the catalyst-imparting unit 7, the pure water cleaning unit 8, the plating unit 9, and the cleaning and drying unit 10 is made in low oxygen concentration condition. Although it is ideal to make the overall apparatus in low oxygen concentration condition, as far as an atmosphere outside the apparatus does not become in low oxygen concentration state, a process for replacing the atmosphere with a low oxygen concentration atmosphere is required in the apparatus. Therefore, in the embodiment shown in FIG. 4, this replacement process is carried out in the atmospheric gas replacement chambers 3. The atmospheric gas replacement chamber 3 has a means or a device (not shown) for supplying a low oxygen concentration gas therein or discharging the gas therefrom. Further, the pretreatment unit 5, the pure water cleaning unit 6, the catalyst-imparting unit 7, the pure water cleaning unit 8, the plating unit 9, and the cleaning and drying unit 10 have a means or a device for supplying pure water, a metal catalyst solution, and an electroless plating solution therein or discharging pure water, a metal catalyst solution, and an electroless plating solution therefrom, respectively, and a device for reducing dissolved oxygen concentration in the respective liquids, respectively.

In the plating apparatus, the wafer W on which interconnects are formed is introduced from the loading/unloading unit 1 into the atmospheric gas replacement chamber 3 by the transfer robot 2, and normally an atmospheric gas is replaced from the atmosphere to a low oxygen concentration atmosphere. In the embodiment shown in FIG. 4, there are provided two atmospheric gas replacement chambers 3, and while gas replacement is performed in one of the atmospheric gas replacement chamber 3, the wafer can be carried in or carried out in the other atmospheric gas replacement chambers 3, thus reducing time loss caused by gas replacement.

Next, the wafer is introduced into the low oxygen concentration atmosphere by the transfer robot 4, and cleaning treatment or activation treatment by chemicals is performed in the pretreatment unit 5. Since chemicals are used in the pretreatment unit 5, there is a possibility that an unexpected gas or the like is generated in the pretreatment unit 5. Therefore, the gas discharged from the exhaust ports 13 is not circulated as it is, but is preferably delivered to the exhaust gas treatment apparatus without being discharged to the outside of the apparatus as it is. Dissolved oxygen concentration of a pretreatment liquid used in the pretreatment unit 5 is reduced, and the interiors of the unit and the entire apparatus are kept under low oxygen concentration condition, and hence dissolved oxygen concentration is hardly increased in the pretreatment process and the subsequent transfer process.

The wafer which has been subjected to the pretreatment is transferred to the pure water cleaning unit 6 by the transfer robot 4, and is cleaned to wash away the chemicals in the pure water cleaning unit 6. Dissolved oxygen concentration of pure water used in the pure water cleaning unit 6 is reduced, and the interior of the unit is kept under low oxygen concentration condition, and hence dissolved oxygen concentration is hardly increased in the cleaning process and the subsequent transfer process. Particularly, since an unexpected gas is hardly generated, a gas discharged from the exhaust ports 13 is delivered to the gas circulating unit 14.

Next, the cleaned wafer is delivered from the pure water cleaning unit 6 to the catalyst-imparting unit 7, and a catalyst layer is formed in the catalyst-imparting unit 7. In the catalyst-imparting unit 7, since a liquid containing an electrolyte is used, an unexpected gas tends to be generated. Therefore, the gas discharged from the exhaust ports 13 is not circulated as it is, but is preferably delivered to the exhaust gas treatment apparatus without being discharged to the outside of the apparatus as it is. Dissolved oxygen concentration of the metal catalyst solution used in the catalyst-imparting unit 7 is reduced, and the interior of the unit is kept under low oxygen concentration condition, and hence dissolved oxygen concentration in the metal catalyst solution is hardly increased.

Under such conditions, the wafer on which the catalyst layer is formed is transferred to the pure water cleaning unit 8, and then to the plating unit 9 for forming a capping film by electroless plating by the transfer robot 4. In the plating unit 9, a capping film is formed. With regard to liquids used in the plating unit 9, dissolved oxygen concentration is not required to be reduced, and for convenience of carrying in and carrying out the wafer, the interior of the unit is kept under low oxygen concentration condition. Further, there is a possibility that a gas or the like tends to be generated from the plating solution. Therefore, the gas discharged from the exhaust ports 13 is not circulated as it is, but is preferably delivered to the exhaust gas treatment apparatus without being discharged to the outside of the apparatus as it is.

Then, the wafer on which the capping film is formed is transferred to the cleaning and drying unit 10 by the transfer robot 4. At this stage, the interconnect metal is not exposed to the atmosphere, and thus dissolved oxygen concentration is not required to be reduced. However, for convenience of carrying in and carrying out the wafer, the interior of the unit is kept under low oxygen concentration condition. Depending on the cleaning process, the gas discharged from the exhaust ports 13 is not circulated as it is, but is preferably delivered to the exhaust gas treatment apparatus without being discharged to the outside of the apparatus as it is. Thereafter, the wafer is introduced into the atmospheric gas replacement chamber 3 by the transfer robot 4, and is then transferred to the loading/unloading unit 1 by the transfer robot 2. Next, the wafer is transported from the loading/unloading unit 1 to the subsequent process.

In another embodiment, a chemical solution treatment unit and a pure water cleaning unit may be integrated. Specifically, a single unit may have a function of the pretreatment unit 5 and a function of the pure water cleaning unit 6. Similarly, a single unit may have a function of the catalyst-imparting unit 7 and a function of the pure water cleaning unit 8.

In the apparatus according to the present invention, the gas supply unit 11 for reducing oxygen concentration may use an inert gas. Alternatively, the gas supply unit 11 for reducing oxygen concentration can use a method for removing oxygen in the gas to be circulated. Further, in the gas supply unit 11 for reducing oxygen concentration, a gas flow rate is preferably adjusted according to oxygen concentration in the apparatus.

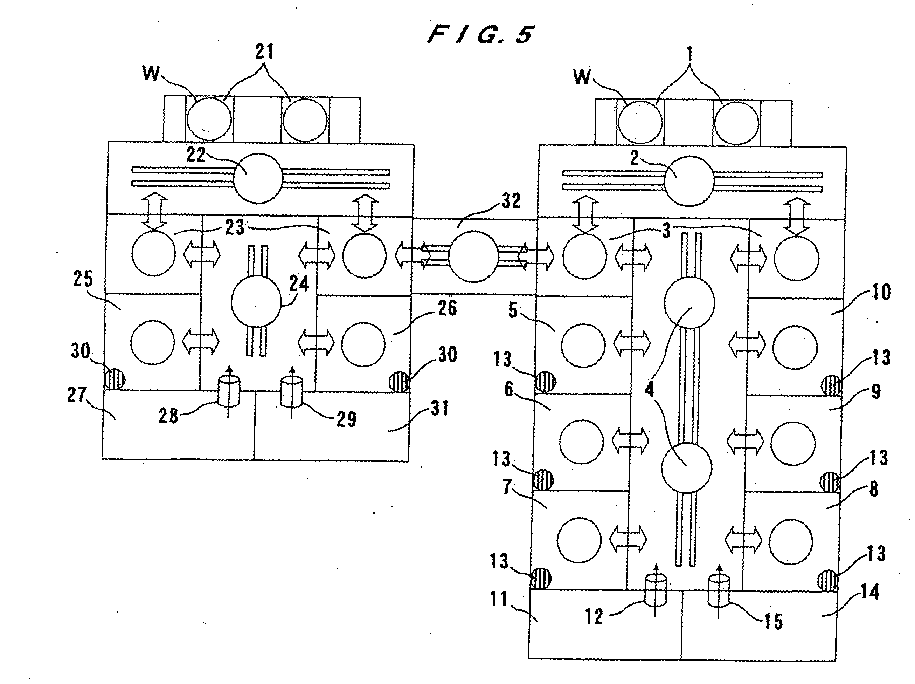

In the apparatus unit used in the planarization process such as CMP, oxygen concentration is reduced as in the apparatus shown in FIG. 4. FIG. 5 shows an example of an overall structure of an apparatus which combines the planarization apparatus and the capping film forming apparatus shown in FIG. 4.

Specifically, FIG. 5 is a schematic plan view showing an overall structure of the apparatus in which various processes from the planarization process to the capping film forming process according to the method of the present invention are performed. The planarization apparatus comprises a loading/unloading unit 21, a transfer robot 22, atmospheric gas replacement chambers 23, a transfer robot 24, a planarization unit 25, and a cleaning and drying unit 26. The planarization apparatus further comprises a gas supply unit 27 for reducing oxygen concentration which can control the temperature and humidity in the apparatus, a gas supply port 28 for reducing oxygen concentration, a circulating gas supply port 29, exhaust ports 30 provided in the respective units for circulating a gas or discharging the gas to an exhaust gas treatment apparatus, and a gas circulating unit 31 for circulating a gas through the exhaust ports 30. A wafer transfer unit 32 is provided to couple the planarization apparatus and the plating apparatus, and can transfer a wafer under low oxygen concentration condition.

According to the apparatus of the present invention, a low oxygen concentration state can be created in each unit and each device, and the wafer can be transferred in such a state that low oxygen concentration state can be kept between the units by the wafer transfer unit 32. The wafer transfer unit 32 can transfer the wafer in a dry state as well as a wet state.

By using the wafer transfer unit 32, in the atmospheric gas replacement chambers 3 and 23 in the respective apparatuses adjacent to the transfer unit 32, gas replacement is basically eliminated, thus shortening a processing time and saving an inert gas. Further, since the wafer is transferred in a wet state by the wafer transfer unit 32, the danger of attachment of particles caused by drying of the wafer is eliminated. Further, oxidization of copper interconnects can be suppressed, and a capping film can be formed while keeping a wet state, and hence an ideal protective film can be formed.

However, if a process in which the surface of the wafer is modified in a dry state is necessary as a finish step of the planarization process, the wafer may be transferred in a low oxygen concentration atmosphere and a dry state by the transfer robot 32.

Instead of the coupling system as shown in FIG. 5, all the units for performing processes from a planarization process to a capping plating process may be constructed in a single apparatus, and a low oxygen concentration state may be created. However, if a new process is added to the processes from the planarization process to the capping film forming process, the coupling system as shown in FIG. 5 may easily cope with such addition of the new process.

The catalyst-imparting treatment method includes a spray method and a soaking method. The soaking method is more preferable because oxygen concentration of an atmosphere around the wafer can be well controlled during processing.

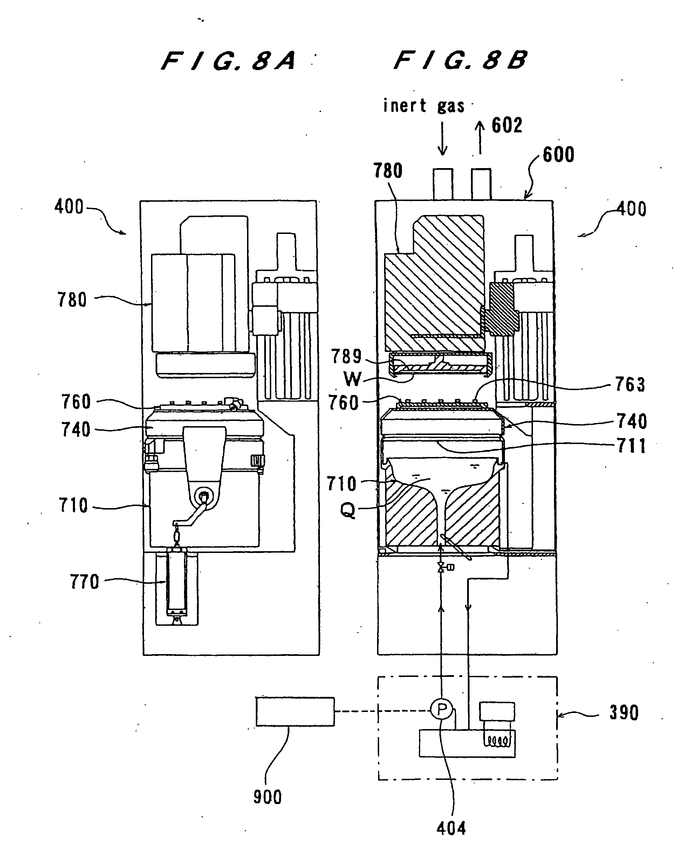

Structure of a soaking type catalyst-imparting unit and a management method of oxygen concentration will be described according to an embodiment of the present invention. In this embodiment, as shown in FIGS. 8A and 8B, a single unit has a catalyst-imparting function and a cleaning function after treatment. Sections or units other than a chemical solution supply unit 390 and a control unit 900 are enclosed by a semi-closed housing 600. The housing 600 has an opening 602 for supplying an inert gas or circulating an inert gas.

At the time of catalyst-imparting treatment, the lid member 740 is opened, and the substrate W to be processed is lowered to a processing tank 710 and soaked in the chemical solution, thereby processing the substrate W. Thereafter, the substrate W is raised, and the lid member 740 is closed, and then deionized water (DIW) is supplied from the nozzles 763 to the substrate W, thereby cleaning the substrate W.

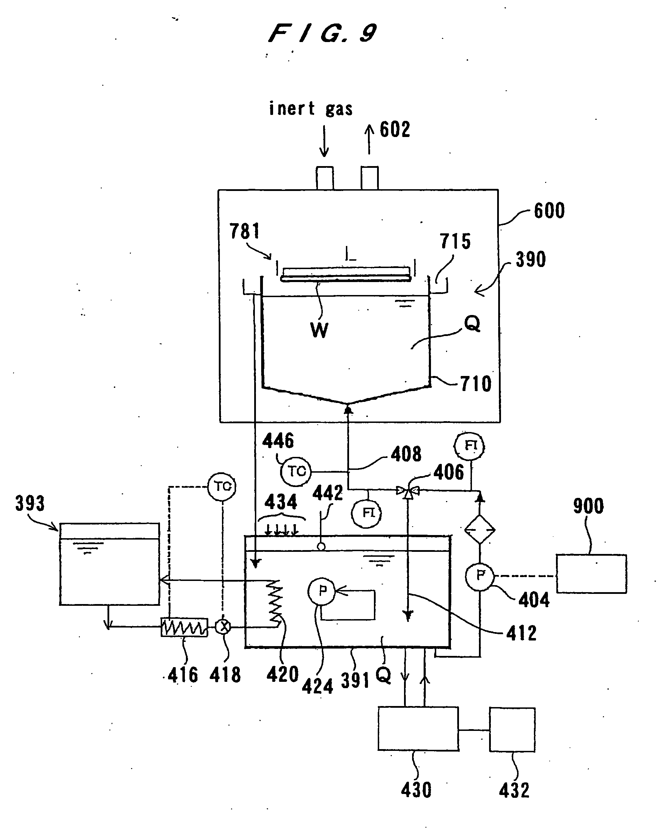

FIG. 9 shows a chemical solution supply unit 390 in detail. A chemical solution supply pipe 408 extending from a chemical solution storage tank 391 and having a chemical solution supply pump 404 and a three-way valve 406 is connected to the processing tank 710 at the bottom of the processing tank 710. With this arrangement, during a chemical solution treatment process, a chemical solution Q is supplied into the processing tank 710 from the bottom of the processing tank 710, and the overflowing chemical solution Q is recovered by the chemical solution storage tank 391 through the chemical solution recovery groove 715 provided around the processing tank 710. Thus, the chemical solution can be circulated. A chemical solution return pipe 412 for returning the chemical solution Q to the chemical solution storage tank 391 is connected to one of the ports of the three-way valve 406. Thus, a chemical solution circulating system in which the chemical solution Q can be circulated even in a standby condition is constructed. As described above, the chemical solution Q in the chemical solution storage tank 391 is always circulated through the chemical solution circulating system, and hence a lowering rate of the concentration of the chemical solution Q can be reduced and the number of the substrates W which can be processed can be increased, compared with the case in which the chemical solution Q is simply stored.

Particularly, in this embodiment, by controlling a discharge flow rate of the chemical solution supply pump 404 with the control unit 900, the flow rate of the chemical solution Q which is circulated in a standby condition or in a chemical solution treatment process can be set individually. With this arrangement, a large amount of circulating chemical solution in the standby condition can be ensured to keep a concentration of the chemical solution Q in the chemical solution storage tank 391, a filtering efficiency, and a temperature of the chemical solution constant, and, if necessary, the flow rate of the circulating chemical solution Q is made smaller in the chemical solution treatment process to perform more uniform chemical solution treatment.

The thermometer 466 provided in the vicinity of the bottom of the processing tank 710 measures a temperature of the chemical solution introduced into the processing tank 710, and controls a heat exchanger 416 and a flow meter 418 described below on the basis of the measured results.

Specifically, in this embodiment, there are provided a heating device 393 for heating the chemical solution Q indirectly by a heat exchanger 420 which is provided in the chemical solution Q in the chemical solution storage tank 391 and uses water as a heating medium which has been heated by a separate heat exchanger 416 and has passed through the flow meter 418, and a stirring pump 424 for mixing the chemical solution Q by circulating the chemical solution Q in the chemical solution storage tank 391. This is because, in some cases, the catalyst solution is used at a temperature range greatly different from room temperature, and the structure should cope with such cases.

The chemical solution supply unit 390 is provided with a liquid level sensor 442 for detecting a liquid level of the chemical solution Q in the chemical solution storage tank 391, and a chemical solution management unit 430 for analyzing composition of the chemical solution Q by an absorptiometric method, a titration method, an electrochemical measurement, or the like, and replenishing components which are insufficient in the chemical solution Q. In the chemical solution management unit 430, signals indicative of the analysis results are processed to replenish insufficient components in the chemical solution Q from a replenishment tank (not shown) through the replenishment unit 434 to the chemical solution storage tank 391 using a metering pump, thereby controlling the amount of the chemical solution Q and composition of the chemical solution Q.

In this embodiment, the chemical solution Q in the chemical solution storage tank 391 is prepared to be within a predetermined volume and within a predetermined concentration by feedback control. The consuming state or the concentration variation of the chemical solution Q in the chemical solution storage tank 391 is estimated in advance on the basis of the number of the substrates which have been processed, a temperature of the chemical solution, a processing time, and the like, and components constituting the chemical solution are added individually or in a mixed state on the basis of the estimated results by feedforward control. Further, the chemical solution Q in the chemical solution storage tank 391 may be prepared to be within a predetermined volume and a predetermined concentration by a combination of feedback control and feedforward control.

Further, the temperature of the chemical solution Q supplied to the processing tank 710 is adjusted within a predetermined range, whereby the concentration of the chemical solution Q can be maintained within a predetermined range, a flowing state of the chemical solution in the processing tank 710 during supply of the chemical solution Q can be uniformized, and the uniformity of reaction within the surface of the substrate can be further enhanced. The temperature of the chemical solution Q may be room temperature or lower, or room temperature or higher.

The chemical solution management unit 430 has a dissolved oxygen densitometer 432 for measuring dissolved oxygen in the chemical solution Q by an electrochemical method, for example. According to the chemical solution management unit 430, the dissolved oxygen concentration in the chemical solution Q can be controlled at a constant value by deaeration, nitrogen blowing, or other methods on the basis of indication of the dissolved oxygen densitometer 432. In this manner, the dissolved oxygen concentration in the chemical solution Q can be controlled at a constant value and this arrangement can cope with the case in which dissolved oxygen exerts an adverse influence on the reaction of treatment of the substrate W.

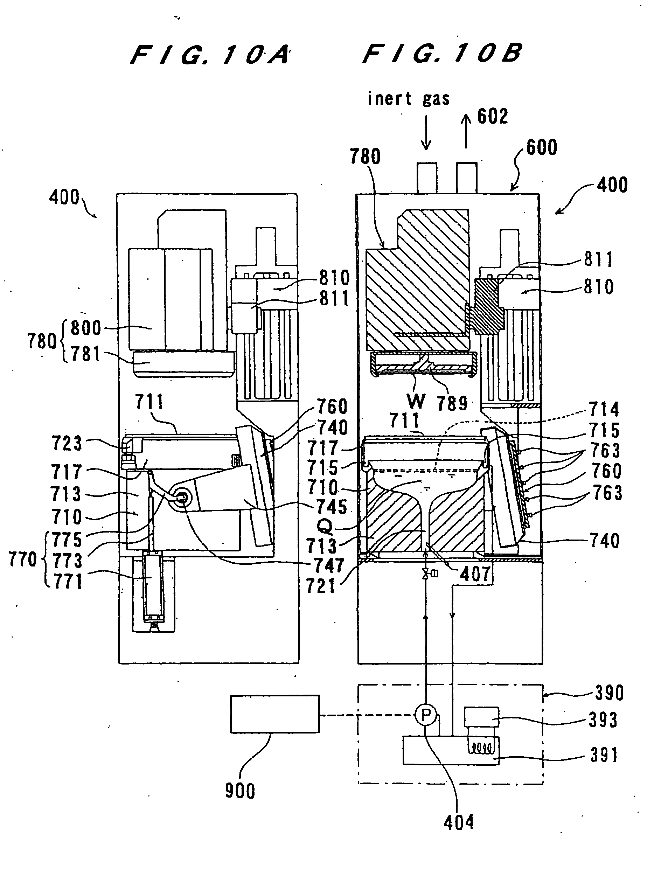

Next, the overall operation of the catalyst-imparting treatment apparatus 400 will now be described. FIGS. 10A and 10B show the state in which the lid member 740 is turned to open the opening 711 of the processing tank 710, and the substrate holder 780 is raised. Thus, the lid member 740 is moved to the retreat position beside the processing tank 710. At this time, the chemical solution supply unit 390 is operated, and the chemical solution Q is circulating between the processing tank 710 and the chemical solution storage tank 391 while the chemical solution Q is kept at a predetermined temperature.

In this state, a substrate W to be processed is held by the holding head 789 of the substrate holder 780. Then, the substrate W held by the holding head 789 is placed immediately above the processing tank 710. Next, the whole substrate holder 780 is swung by the tilting mechanism 811 to tilt the substrate W held by the holding head 789 at a predetermined angle θ from the horizontal position. The tilt angle θ of the substrate W is in the range of 1.5 to 15 degrees, preferably in the range of 1.5 to 10 degrees with respect to the horizontal plane.

In some cases, in a soaking type wet treatment in which a surface (surface to be processed) of a substrate faces downwardly, when the substrate is brought into contact with the chemical solution, air accompanied by the substrate or bubbles of gas generated by reaction are attached to or remain on the surface of the substrate depending on the property of the chemical solution. These bubbles may cause non-uniformities such as non-uniformity in case of bringing the surface of the substrate W into contact with chemical solution or non-uniformity of temperature in the surface of the substrate W. Accordingly, the bubbles are a primary factor to degrade the uniformity of treatment within the surface of the substrate. According to this embodiment, the substrate W is soaked in the chemical solution Q in such a state that the substrate W is tilted at the tilt angle θ, and thus the bubbles accompanied by the substrate upon contacting the liquid are caused to move along the surface of the substrate to the outside of the substrate with a liquid flow, and are removed from the surface of the substrate. In this case, the tilt angle θ of the substrate W is in the range of 1.5 to 15 degrees, preferably in the range of 1.5 to 10 degrees with respect to the horizontal plane, and the surface of the substrate W is brought into contact with the chemical solution Q in such a state that at least the tilt angle θ is maintained, thus preventing the period of time from contact of part of the surface of the substrate W with the chemical solution Q to contact of the entire surface of the substrate W with the chemical solution Q from being prolonged and preventing bubbles from being hard to exclude.

Next, a substrate holder drive mechanism 810 is actuated, the substrate holder 780 is rapidly lowered at a first speed until the surface of the substrate W approaches the liquid level of the chemical solution Q in the processing tank 710, and then the substrate holder 780 is suspended. Specifically, the substrate holder 780 is rapidly lowered at a first speed of about 300 mm/sec., for example to the position where the substrate W approaches the liquid level of the chemical solution Q, for example, the position where the lowermost part of the substrate W is spaced from the liquid level of the chemical solution Q by a distance of 10 mm or less, and is then stopped. Thereafter, the substrate holder 780 is further lowered at a second speed which is lower than the first speed, and the substrate W held by the holding head 789 of the substrate holder 780 is soaked in the chemical solution Q. That is, the substrate W is lowered at a proper speed (second speed) of, for example, 10 mm/sec. or less so as not to disturb a liquid flow of the chemical solution and is soaked in the chemical solution Q in the processing tank 710, thereby processing the surface of the substrate W by the chemical solution Q.

By employing the above treatment, it is feasible to reduce the period of time when the surface of the substrate W is brought into contact with the steam, the mist, or the like existing above the surface of the chemical solution Q and is affected by the chemical solution components contained therein. Further, it is possible to soak the substrate W into the chemical solution Q without generating current turbulence of the chemical solution Q which hinders the uniformity of treatment. Thus, the uniformity of treatment within the surface of the substrate can be enhanced.

Instead of moving the substrate W vertically, the liquid level of the chemical solution Q may be vertically moved, or both of the substrate W and the liquid level of the chemical solution Q may be moved in combination.

The tilt angle θ of the substrate W and the second speed of the substrate holder 780 are set such that the entire surface of the substrate W is brought into contact with the chemical solution Q within 5% of the processing time by the chemical solution, preferable within 3% of the processing time by the chemical solution.

In a case where the surface of the substrate W is soaked in the chemical solution Q and processed by the chemical solution Q in such a state that the processing surface of the substrate W faces downwardly, the chemical solution Q is continuously supplied into the processing tank 710, as described above, and hence the chemical solution Q in the processing liquid 710 in which an upward flow is formed has a liquid level which is slightly fluctuated. Therefore, it is technically difficult to bring the entire surface of the substrate into contact with the chemical solution completely at the same time, unlike the spray method. In this embodiment, the period of time from contact of part of the surface of the substrate with the chemical solution to contact of the entire surface of the substrate with the chemical solution is kept within 5% of the processing time by the chemical solution, preferably within 3% of the processing time by the chemical solution, whereby the entire surface of the substrate is brought into contact with the chemical solution substantially simultaneously to achieve uniform processing of the entire surface of the substrate by such relatively simple means.

In a case where bubbles are generated by reaction, it is desirable for removing bubbles that the substrate W is tilted during soaking of the substrate W in the chemical solution Q. However, in a case where the substrate W is processed in an inclined state, the substrate W is processed in a non-uniform flow of the chemical solution Q against the substrate W, thus hindering the entire surface of the substrate W from being processed uniformly by the chemical solution. Therefore, if there is no danger of generating bubbles by reaction, the substrate holder 780 in its entirety is swung to be returned to its original position by the tilt mechanism 811, and the substrate W is processed in the horizontal state. In this case, the substrate W may be gradually returned to the horizontal state during the period of time from contact of part of the surface of the substrate W with the chemical solution Q to contact of the entire surface of the substrate W with the chemical solution Q, or the substrate may be returned to the horizontal state after the entire surface of the substrate W is brought into contact with the chemical solution Q.

When the substrate W is soaked in the chemical solution Q and is processed, if necessary, the substrate W is rotated. In this manner, while the substrate W is soaked in the chemical solution Q, the substrate W is rotated, whereby inhibition of reaction caused by attachment of bubbles to certain parts of the surface of the substrate W can be avoided, and removal of the bubbles from the surface of the substrate W can be promoted, thereby improving the uniformity of processing within the surface of the substrate. Further, the contact between the chemical solution Q and the surface of the substrate W can be uniformized, and in this respect also, the uniformity of processing within the surface of the substrate can be improved. If the rotational speed of the substrate W is too high, the speed of upward flow of the chemical solution becomes non-uniform. Therefore, the rotational speed of the substrate W is preferably 300 rpm or less, more preferably 100 rpm or less.

When the substrate W is processed by soaking the substrate W in the chemical solution Q, the substrate W held by the substrate holder 780 may be moved up and down in the chemical solution Q by the substrate holder drive mechanism 810. In general, the amount of bubbles generated by reaction and attached to the substrate W is smaller than the amount of bubbles which are accompanied by the surface of the substrate W upon contact with the chemical solution Q and are attached to the substrate W. In this manner, while the substrate W is soaked in the chemical solution Q, the substrate W is moved up and down relative to the chemical solution Q, and hence removal of the bubbles from the surface of the substrate W can be accelerated and especially the bubbles accompanied by the surface of the substrate W upon contact with the chemical solution Q and attached to the surface of the substrate W can be effectively removed from the surface of the substrate W.

Further, in some cases, pretreatment is applied to the surface of the substrate W before the surface of the substrate W is brought into contact with the chemical solution Q. In such cases, the pretreatment liquid or the cleaning liquid used after the pretreatment is attached to the surface of the substrate W. In this state, when the surface of the substrate W is brought into contact with the chemical solution Q, the chemical solution Q is diluted on the surface of the substrate W immediately after the contact. In this case, the surface of the substrate W is not sufficiently processed for at least a certain period of time. Further, in some cases, processing conditions between a plurality of substrates may differ from one another. Thus, for example, by adding operation of moving the substrate W up and down, the pretreatment liquid or the cleaning liquid used after the pretreatment is effectively removed from the surface of the substrate W, whereby the state in which the concentration of the chemical solution Q is thin can be prevented from being prolonged. In this case also, the liquid level of the chemical solution Q may be raised or lowered.

As described above, the chemical solution supply unit 390 is operated, and the chemical solution Q is circulated between the processing tank 710 and the chemical solution storage tank 391 while the chemical solution Q is kept at a predetermined temperature. Specifically, an upward flow is formed in the chemical solution Q in the processing tank 710. For target processing of the substrate W, a flow velocity of the chemical solution Q cannot be too high in view of the uniformity within the surface of the substrate, but the flow velocity of the chemical solution Q in the processing tank 710 may be increased by increasing the amount of the chemical solution Q supplied into the processing tank 710 when the substrate W is soaked in the chemical solution Q. In this manner, when the substrate W is soaked in the chemical solution Q, a higher flow velocity of the chemical solution Q is formed in the processing tank 710, whereby removal of bubbles accompanied by the surface of the substrate W upon contact with the chemical solution Q and attached to the surface of the substrate W can be accelerated by the flow of the chemical solution Q. Further, in the same manner as the above, even if the concentration of the chemical solution Q on the surface of the substrate W is thin immediately after contact of the substrate W with the chemical solution Q, the pretreatment liquid or the cleaning liquid used after the pretreatment can be replaced with the chemical solution by the flow of the chemical solution Q, thus preventing the state in which the concentration of the chemical solution is thin on the surface of the substrate W from being prolonged. The flow velocity of the chemical solution Q is increased only at the time required for removal of bubbles or replacement of the liquid, and then lowered to a certain value, and the substrate is processed.

After carrying out chemical solution treatment of the processing surface (lower surface) of the substrate W for a predetermined time, as described above, the substrate holder drive mechanism 810 is driven to raise the substrate holder 780 to the position shown in FIGS. 10A and 10B. Next, the drive mechanism 770 is driven to turn the lid member 740 so as to close the opening 711 with the lid member 740, as shown in FIG. 8B.

Next, a cleaning liquid (pure water) is sprayed right upwardly from the nozzles 763 of the spray nozzle 760 on the lid member 740 onto the processing surface of the substrate W to clean the processing surface. At this time, since the opening 711 of the processing tank 710 is closed with the lid member 740, the cleaning liquid does not enter the processing tank 710, and hence the chemical solution Q in the processing tank 710 is not diluted, thus enabling use of the chemical solution Q during circulating. The cleaning liquid which has been used for cleaning the substrate W is discharged from a discharge outlet (not shown). The substrate W which has been cleaned is taken out of the substrate holder 780 by the vacuum hand of the substrate transfer robot (not shown) in the above-described manner, and a next substrate W to be processed is set in the substrate holder 780. Thus, the substrate W is subjected to the above-described plating and cleaning processes.

According to the method of the present invention, when the catalyst layer is formed on the surface of the interconnect metal, dissolution reaction of copper caused by dissolved oxygen which takes place simultaneously with replacement reaction for forming the catalyst layer can be prevented from occurring by reducing dissolved oxygen concentration in the metal catalyst solution. Specifically, the metal catalyst solution is deaerated, dissolved oxygen concentration is reduced, and if necessary, the solution used in the planarization process such as CMP which is the previous process is deaerated, and further an atmosphere (gas) contacting the metal catalyst solution and/or an atmosphere between the previous process and the present process are made under low oxygen concentration condition using an inert gas or the like, whereby the dissolution reaction is prevented.

By preventing dissolution reaction of copper as side reaction from occurring, excess dissolution (etching) of copper or formation of voids can be prevented, and ideal low resistance copper interconnects can be achieved.

Further, by suppressing the competitive reaction of copper dissolution caused by dissolved oxygen, the replacement reaction of palladium on the surface of copper can occur selectively. Accordingly, the catalyst layer of palladium can be formed more effectively. As a result, for example, the adhesiveness at the interface between copper and a CoWP film can be improved, and high electromigration resistance of copper interconnects can be obtained.

### [Examples]

Specific examples according to the present invention will be described in detail. The present invention is not limited to the following examples.

### Example 1

Confirmation of variations of dissolution of copper in a case where deaeration is carried out or in a case where deaeration is not carried out:

The difference of variation of weight of copper was evaluated by using Electrochemical Quartz Crystal Microbalance in a case where a palladium sulfate solution was deaerated to create low oxygen concentration state and in a case where a palladium sulfate solution was not deaerated.

First, platinum was deposited on a crystal oscillator (manufactured by BAS Inc.) to produce a platinum electrode. Next, copper is deposited by a film thickness of about 0.1 µm on the platinum electrode using a plating solution used for formation of fine copper interconnects by electroplating.

On the other hand, a mixed liquid containing 50mg/L of palladium sulfate and 50g/L of sulfate was prepared as a catalyst-imparting solution. Then, the catalyst-imparting solution was deaerated to lower dissolved oxygen concentration to 1 ppm or less, thereby producing low oxygen concentration state by bubbling nitrogen (deaerated catalyst-imparting solution).

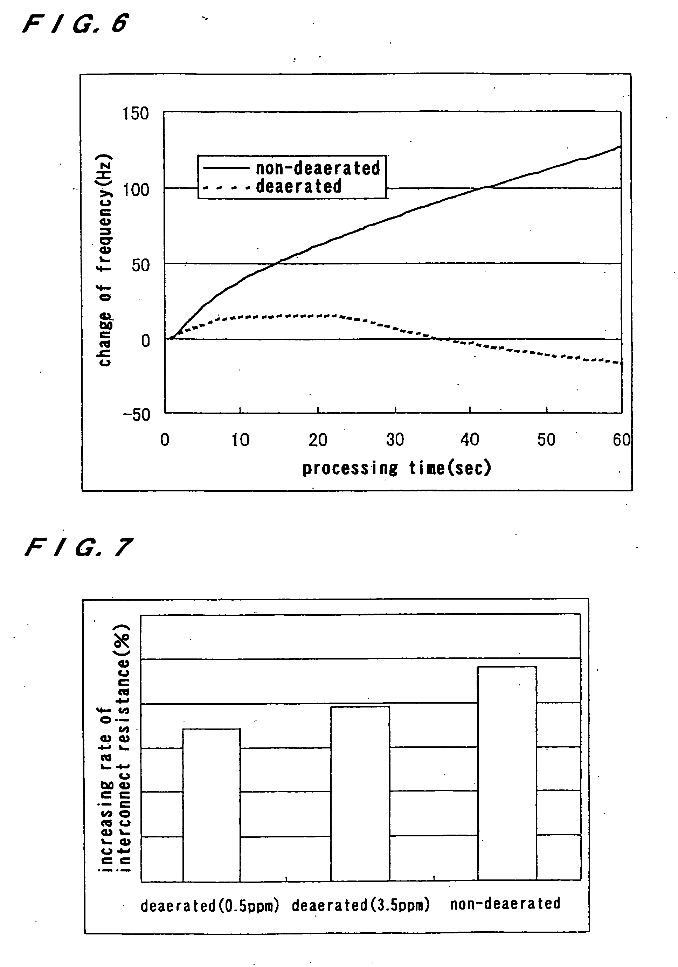

The platinum electrode plated with copper was soaked in the deaerated catalyst-imparting solution, and the change of frequency with time was investigated. Further, the platinum electrode plated with copper was soaked in the non-deaerated catalyst-imparting solution, and the change of frequency with time was investigated. The difference of change of weight in each case is shown in FIG. 6.

In FIG. 6, the increase of frequency indicates reduction of weight of the electrode. If only replacement reaction of copper and palladium takes place purely, because this reaction is a replacement of one copper element with one palladium element whose mass is larger than that of copper, the change of measured frequency must show a decreasing tendency. However, in a case where deaeration is not carried out, the frequency increases actually, and thus it is understood that copper is resolved separately from replacement reaction. In a case where deaeration is performed to produce low oxygen concentration state, it is understood that tendency of increase of the frequency is suppressed.

As is apparent from the above, it can be said that dissolution of copper is reduced by deaeration. Although not shown in the drawing, it was confirmed that as dissolved oxygen concentration of catalyst-imparting solution was smaller than 7 ppm, the amount of dissolved copper was reduced more.

### Example 2

The relationship between dissolved oxygen concentration of a catalyst-imparting solution and interconnect resistance:

A catalyst-imparting solution containing 50mg/L of palladium sulfate and 50g/L of sulfate was prepared, and deaerated to various levels by bubbling nitrogen. According to the conventional method, electroplating was performed on the wafer, and then CMP was performed on the plated wafer to form copper interconnects. Then, catalyst was imparted to the copper interconnects using the catalyst-imparting solution, and then a cobalt tungsten phosphide (CoWP) film was formed by electroless plating under the following composition and conditions.

| (CoWP electroless plating solution) | |
|---|---|
| composition: | |
| sodium hypophosphite | 10g/L |
| cobalt sulfate | 4g/L |
| sodium citrate | 40g/L |
| boric acid | 30g/L |
| sodium tungstate | 6g/L |

| conditions: | |
|---|---|
| temperature of the solution | 75°C |
| pH | 9 |

| (sodium hydroxide was used for adjustment of pH) | |
|---|---|
| agitation | No |

The interconnect resistance of copper interconnects before and after CoWP electroless plating was measured by a measuring device which combined Prober (manufactured by MICRONICS JAPAN CO., LTD.) and Parameter Analyzer (manufactured by Agilent Technologies), and the effect of deaeration was evaluated by an increasing rate of interconnect resistance. The results are shown in FIG. 7.

As shown in the results, it was confirmed that in a case where the catalyst-imparting solution was deaerated to lower dissolved oxygen concentration to 0.5 ppm and 3.5 ppm and in a case where deaeration was not performed, the increasing rate of interconnect resistance was smaller in the case where deaeration was performed than in the case where deaeration was not carried out. Further, it was confirmed that the smaller dissolved oxygen concentration was, the smaller the increasing rate of interconnect resistance was. That is, it was confirmed that by forming a capping film under low oxygen concentration condition created by deaeration, copper interconnects having essential performance without impairing low resistance could be produced.

According to the present invention, since the catalyst-imparting solution containing metal catalyst is deaerated to lower dissolved oxygen concentration, reduction reaction of oxygen (i.e. oxygen is subjected to reduction reaction) can be suppressed, abnormal dissolution reaction of copper can be reduced, and low resistance of copper interconnects can be maintained.

Further, by suppressing the competitive reaction of copper dissolution caused by dissolved oxygen, the replacement reaction of palladium on the surface of copper can occur selectively. Accordingly, the catalyst layer of palladium can be formed more effectively. As a result, the adhesiveness at the interface between copper and the CoWP film can be improved, and high electromigration resistance of copper interconnects can be obtained.

Accordingly, the present invention is useful in applying copper interconnects to devices as circuit materials with low resistance and high reliability, and the present invention can be used advantageously especially in producing fine devices in which signal transmission delay is problematic.

Although certain preferred embodiments of the present invention have been shown and described in detail, it should be understood that various changes and modifications may be made therein without departing from the scope of the appended claims.

## Claims

1. A method for forming a capping film for protecting a surface of interconnect metal, comprising:
preparing a metal catalyst solution for electroless plating containing a metal element nobler than interconnect metal and having dissolved oxygen concentration of 7 ppm or less;
bringing said metal catalyst solution into contact with a surface of the interconnect metal to form a metal catalyst layer on the surface of the interconnect metal; and
performing electroless to form a capping film on the surface of the interconnect metal.

2. A method according to claim 1, wherein said interconnect metal comprises copper or copper alloy, and said metal element nobler than the interconnect metal comprises at least one of metal element selected from gold, silver, and platinum group metals.

3. A method according to claim 1, wherein an apparatus used for the step for forming the metal catalyst layer on the surface of the interconnect metal is placed in an atmosphere in which oxygen concentration is lower than oxygen concentration in the normal atmosphere.

4. A method according to claim 1, wherein formation of the metal catalyst layer is performed by replacement reaction of metal of the interconnect metal with metal catalyst.

5. A method according to claim 1, wherein said metal catalyst solution which dissolves palladium in inorganic acid or organic acid or a mixed solvent of inorganic acid and organic acid is used for forming said metal catalyst layer.

6. A method according to claim 1, wherein said capping film comprises a film containing at least one component selected from CoWP, NiP, NiB, CoP, NiWP, NiCoP, CoWB, NiWB, CoMoP, CoMoB and CoB.

7. A method according to claim 1, wherein a step before the step for forming the metal catalyst layer on the surface of the interconnect metal comprises a planarization step of an interconnect substrate by a wet process, and oxygen concentration of an atmosphere between units used for said planarization step and the step for forming the metal catalyst layer on the surface of the interconnect metal and within said units is lower than that of the normal atmosphere.

8. An apparatus for forming a capping film for protecting a surface of interconnect metal, comprising:
a catalyst-imparting unit for bringing a metal catalyst solution for electroless plating containing a metal element nobler than interconnect metal into contact with a surface of the interconnect metal and forming a metal catalyst layer on the surface of the interconnect metal; and
a plating unit for forming a capping film on the surface of the interconnect metal by electroless plating;
wherein said catalyst-imparting unit has a device configured to supply and discharge the metal catalyst solution and said plating unit has a device configured to supply and discharge a plating solution;
at least said catalyst-imparting unit is placed in a housing which limits an inflow of outer air;
said catalyst-imparting unit comprises a deaeration device configured to deaerate the metal catalyst solution; and
said housing for said catalyst-imparting unit comprises a low oxygen concentration device configured to replace an atmosphere in said housing with an inert gas or a low oxygen concentration gas.

9. An apparatus according to claim 8, wherein said deaeration device lowers dissolved oxygen concentration in the metal catalyst solution to 7 ppm or less.

10. An apparatus according to claim 8, wherein said interconnect metal comprises copper, said metal catalyst comprises palladium, and said capping film comprises a film containing at least one component selected from CoWP and NiP.

11. An apparatus according to claim 8, further comprising a planarization unit coupled to said apparatus for forming said capping film, said planarization unit being configured to planarize an interconnect substrate by a wet process;
wherein said planarization unit, said catalyst-imparting unit, and said plating unit and spaces between said units are disposed in a housing which limits an inflow of outer air, and said housing comprises a low oxygen concentration device configured to replace an atmosphere in said housing with an inert gas or a low oxygen concentration gas.
